# EUROPÄISCHE PATENTANMELDUNG

(11) **EP 2 830 400 A1**
(43) Veröffentlichungstag der Anmeldung: **28.01.2015**
(21) Anmeldenummer: 14175559.5
(22) Anmeldetag: 03.07.2014
(51) Int. Cl.: H05K 1/02, G01R 31/28, H05K 3/00, H05K 1/18

(54) **Nutzen mit mehreren Leiterplatten und Verfahren zu seiner Herstellung**

(30) Priorität: 24.07.2013 DE 102013214478
(71) Anmelder: Automotive Lighting Reutlingen GmbH, 72762 Reutlingen (DE)
(72) Erfinder: Blum, Dirk, 72076 Tübingen (DE); Hiegler, Michael, 72760 Reutlingen (DE); Bormann, Uwe, 89520 Heidenheim (DE)
(74) Vertreter: DREISS Patentanwälte PartG mbB

(57) **Zusammenfassung**

Die vorliegende Erfindung betrifft einen Nutzen (10) umfassend mehrere Leiterplatten (12) und einen außerhalb der Leiterplatten (12) angeordneten Nutzenrand (26). Auf mindestens einer der Leiterplatten (12) ist mindestens ein Bauteil (22; 28) angeordnet. Mindestens eines der Bauteile (22) ist über eine Leiterbahn (16'; 30) mit einem Testpunkt (24; 32) zum Überprüfen des bestückten Bauteils (22) elektrisch verbunden. Der Testpunkt (24; 32) ist vorzugsweise auf dem Nutzenrand (26) außerhalb der Leiterplatten (12) angeordnet.

## Beschreibung

Die vorliegende Erfindung betrifft einen Nutzen umfassend mehrere Leiterplatten und einen außerhalb der Leiterplatten angeordneten Nutzenrand. Auf mindestens einer der Leiterplatten ist mindestens ein Bauteil angeordnet, und mindestens eines der Bauteile ist über eine Leiterbahn mit mindestens einem Testpunkt zum Überprüfen des bestückten Bauteils elektrisch verbunden. Die Erfindung betrifft außerdem ein Verfahren zur Herstellung eines solchen Nutzens.

Als Nutzen wird im Rahmen der Fertigung von elektrischen Leiterplatten eine meist kreisförmige Gesamtleiterplatte bezeichnet, die mehrere einzelne Leiterplatten mit definierten Schaltungsfunktionen umfasst. Der Nutzen kann aber auch eine andere als eine kreisförmige Form aufweisen, bspw. eine rechteckige oder quadratische Form. Man spricht daher auch von einem Fertigungsnutzen. Der Nutzen kann mehrere identische Leiterplatten mit gleichem Aufbau, gleichen elektrischen Bauteilen und gleichen Schaltungsfunktionen umfassen; es können aber auch unterschiedliche Schaltungsfunktionen auf den Leiterplatten realisiert sein. Die Leiterplatten werden beim Nutzenaufbau im Wesentlichen nebeneinander in dem Nutzen angeordnet und so im Verbund hergestellt.

Die wesentlichen Fertigungsschritte sind dabei das Erstellen der Leiterbahnen auf den Leiterplatten und das Bestücken der Leiterplatten mit entsprechenden elektrischen aktiven und/oder passiven Bauteilen. Mehrere Bauteile einer Leiterplatte können dabei eine funktionelle Einheit bilden, die als Bauteilgruppe bezeichnet wird, wobei auch alle Bauteile einer komplett bestückten Leiterplatte als Bauteilgruppe bezeichnet werden können. Ein Nutzen umfasst in der Regel mindestens zwei Leiterplatten.

Um die Leiterplatten herum werden z.B. Durchbrüche gemäß einer vorgesehenen Kontur der Leiterplatten in den Nutzen eingebracht, bspw. gefräst, so dass die Leiterplatten am Ende des Fertigungsprozesses lediglich über nicht herausgefräste, die Durchbrüche überbrückende Stege im Nutzen gehalten werden. Zur eigentlichen Verwendung, dem bestimmungsgemäßen Gebrauch, werden die Leiterplatten dann aus dem Nutzen herausgebrochen, herausgeschnitten oder anderweitig vereinzelt.

In der Regel werden die fertig bestückten Leiterplatten gegen Ende des Fertigungsprozesses im Hinblick auf eine ordnungsgemäße Funktion einzeln getestet. Dieser Test kann bereits vor der Vereinzelung der Leiterplatten durchgeführt werden, wenn die Leiterplatte also noch Teil des Nutzens ist. Zum Testen werden auf den Leiterplatten elektrisch leitfähige Testpunkte vorgesehen, die über separate Leiterbahnen die entsprechenden zu testenden Bauteile oder Bauteilgruppen kontaktieren. Auf diese Testpunkte können z.B. Taststifte einer automatischen Prüfeinrichtung aufgesetzt werden. An den Taststiften können elektrische Signale anliegen oder über die Taststifte können elektrische Signale abgegriffen werden. Dabei können einzelne Bauteile auf ihre elektrischen Eigenschaften hin überprüft werden; es können aber auch funktionelle Tests von Bauteilen oder Bauteilgruppen auf der Leiterplatte ausgeführt werden. Insbesondere ist es bekannt, zumindest stichprobenartig zu testen, ob die Leiterplatten ordnungsgemäß mit den elektrischen Bauteilen bestückt worden sind.

Die Testpunkte werden nach der Herstellung der Leiterplatte in der Regel nicht mehr benötigt. Dennoch sind sie auf der Leiterplatte angeordnet und benötigen Fläche auf der Leiterplatte. Die Testpunkte können eventuell auch die Führung anderer Leiterbahnen auf der Leiterplatte behindern, insbesondere dann, wenn die Leiterplatte eine hohe Packungsdichte aufweist. Dies kann zu einer erheblichen Einschränkung des Layouts der Leiterplatte führen.

Zudem können die Testpunkte nicht beliebig auf der Leiterplatte positioniert werden. Es muss verhindert werden, dass die Testpunkte auch nach dem Einbau in die vorgesehene Vorrichtung zur bestimmungsgemäßen Verwendung keinen elektrischen Kontakt zu anderen elektrisch leitenden Teilen der Vorrichtung haben können. Bei einer Anwendung z.B. in einer Beleuchtungseinrichtung eines Kraftfahrzeugs könnte dies z.B. ein Kühlkörper für Leuchtdioden, ein metallischer Reflektor oder ein Metallgehäuse eines Steuergeräts sein. In kritischen Fällen muss eine elektrische Isolierung der Testpunkte vorgesehen werden.

Aufgabe der Erfindung ist es, die genannten Nachteile zu beseitigen.

Zur Lösung der Aufgabe wird erfindungsgemäß vorgeschlagen, dass mindestens ein Testpunkt auf dem Nutzenrand außerhalb der Leiterplatten angeordnet ist. Zur Herstellung eines solchen Nutzens ist ein entsprechendes erfindungsgemäßes Verfahren vorgesehen. Vorzugsweise sind alle Testpunkte des Nutzens auf dem Nutzenrand angeordnet.

Der Nutzenrand dient insbesondere dazu, während der Fertigung der Leiterplatten zum Halten und Handhaben des Nutzens, bspw. um den Nutzen von einer Fertigungsstation zur nächsten zu bewegen. Der Nutzenrand bietet neben den Bereichen, wo er von Haltemitteln (z.B. Greifer, Sauger, etc.) gehalten wird, genügend Fläche, um eine Vielzahl an Testpunkten dort anordnen zu können. Nach der Herstellung der Leiterplatten, aber noch vor der Vereinzelung der Leiterplatten kann anhand der Testpunkte die Funktion der Leiterplatten bzw. der bestückten Bauteile mittels der Testpunkte geprüft werden. Nach dem Testen werden die Testpunkte nicht mehr benötigt, da sie für den bestimmungsgemäßen Einsatz der Leiterplatten in aller Regel nicht erforderlich sind. Die Leiterplatten können nach den bekannten Verfahren aus dem Nutzen herausgetrennt bzw. vereinzelt werden. Der Nutzenrahmen mit den darauf angeordneten Testpunkten kann als Abfall entsorgt werden.

Besonders vorteilhaft ist es bei dem erfindungsgemäßen Nutzen, dass jeder Testpunkt, der auf dem Nutzenrand angeordnet ist, keinerlei Fläche auf der Leiterplatte benötigt. Die Leiterplatten können kleiner und dichter gepackt ausgestaltet werden. Außerdem wird das Layout der elektrischen Schaltung der Leiterplatten durch jeden auf dem Nutzenrand statt auf der Leiterplatte angeordneten Testpunkt weniger bzw. sogar nicht mehr beeinträchtigt.

Ein weiterer Vorteil der Erfindung besteht darin, dass die Testpunkte auf dem Nutzenrand wesentlich näher an den Greifmitteln zum Halten der Leiterplatte angeordnet sind als bisher. Dadurch können im Rahmen der Funktionsprüfung des bestückten Bauteils, der Bauteilgruppe oder der Leiterplatte die Taststifte eines Prüfgeräts mit einer höheren Kraft auf die Testpunkte gedrückt werden, um einen elektrischen Kontakt herzustellen, ohne dass der Nutzen nachgibt. Auf diese Weise kann also ein besonders sicherer und zuverlässiger elektrischer Kontakt zwischen den Taststiften und den Testpunkten erzielt werden.

In einer bevorzugten Ausführungsform ist vorgesehen, dass die mindestens eine Leiterbahn, die den Testpunkt kontaktiert, von dem mindestens einen Bauteil beziehungsweise der Bauteilgruppe auf der Leiterplatte nach außen auf den Nutzenrand geführt ist. Das bedeutet, dass die üblichen Tests zur Überprüfung der Bauteile bzw. Bauteilgruppen für die Leiterplatten durchgeführt werden können. Die dazu erforderlichen Testpunkte sind aber nicht auf der Leiterplatte positioniert, sondern sind außerhalb der Leiterplatte auf dem Nutzenrand angeordnet. Die dadurch frei werdende Fläche auf der Leiterplatte kann für die bestimmungsgemäße Funktion der Leiterplatte genutzt werden oder die Leiterplatte kann durch ein verändertes Layout verkleinert werden.

Ein Aspekt der Erfindung besteht also darin, zumindest einige der Testpunkte von den Leiterplatten weg in den Nutzenrand zu verlagern. Die wesentlichen Vorteile sind einerseits eine mögliche Verringerung der Leiterplattenfläche oder eine höhere Integrationsdichte auf der Leiterplatte und andererseits eine besonders sichere Kontaktierung der auf dem Nutzenrand befindlichen Testpunkte mittels Taststifte eines Prüfgeräts.

Ferner kann vorgesehen sein, dass auf mehreren Leiterplatten Bauteile mit gleichen elektrischen Eigenschaften angeordnet sind und dass auf dem Nutzenrand mindestens ein zusätzliches Bauteil mit den gleichen elektrischen Eigenschaften angeordnet und mit mindestens einem Testpunkt auf dem Nutzenrand elektrisch kontaktiert ist. Das bedeutet, dass der Nutzenrand mit einem Bauteil bzw. einer Bauteilgruppe mit den gleichen elektrischen Eigenschaften bestückt wird, wie die Bauteile bzw. Bauteilgruppen der auf den _Leiterplatten angeordneten Bauteile bzw. Bauteilgruppen. Dieses auf den Nutzenrand duplizierte Bauteil bzw. die Bauteilgruppe wird mit auf dem Nutzenrand angeordneten Testpunkten kontaktiert. Beim Testen kann das duplizierte Bauteil bzw. die Bauteilgruppe genau vermessen werden. Insbesondere können auf diese Weise die elektrischen Eigenschaften der Bauteile bzw. Bauteilgruppen überprüft und geprüft werden, ob der Bestückungsvorgang an sich erfolgreich war. Durch Auswertung des Messergebnisses können dann Rückschlüsse auf die entsprechenden Bauteile bzw. Bauteilgruppe, mit denen die Leiterplatten bestückt wurden, gezogen werden. Es wäre sogar denkbar, den Test auf die auf dem Nutzenrand angeordneten Bauteile bzw. Bauteilgruppen zu beschränken und die auf den Leiterplatten angeordneten Bauteile bzw. Bauteilgruppen nicht mehr separat zu testen. In diesem Fall könnten sogar sämtliche Testpunkte auf den Leiterplatten und die entsprechenden elektrischen Zuleitungen von den Bauteilen bzw. Bauteilgruppen eingespart werden.

Die Rückschlüsse aus der Auswertung der Messergebnisse des Tests der auf dem Nutzenrand angeordneten Bauteile bzw. Bauteilgruppen sind insbesondere dann besonders aussagekräftig und zuverlässig, wenn die auf dem Nutzenrand angeordneten Bauteile bzw. Bauteilgruppen aus dem gleichen Fertigungslos stammen wie die auf den Leiterplatten angeordneten Bauteile bzw. Bauteilgruppen. Beim Testen der auf den Nutzenrand duplizierten Bauteile bzw. Bauteilgruppen kann dann z.B. festgestellt werden, ob der Nutzen versehentlich mit Bauteilen mit nicht vorgesehenen elektrischen Eigenschaften bestückt wurde. Da all diese Bauteile im Nutzen aus dem gleichen Fertigungslos stammen, kann man davon ausgehen, dass ein Fehler, der bei den duplizierten Bauteilen bzw. Bauteilgruppen evtl. detektiert wurde, auch auf den Bauteilen bzw. Bauteilgruppen auf den Leiterplatten vorhanden ist. Auch die Einhaltung von Toleranzen der verwendeten Bauteile kann überprüft werden, da innerhalb eines Fertigungsloses alle Bauteile einem definierten Toleranzrahmen angehören, der exemplarisch anhand der auf dem Nutzenrand angeordneten Bauteile bzw. Bauteilgruppen überprüft werden kann. Auf ein zusätzliches Testen der Bauteile auf den Leiterplatten kann verzichtet werden.

Außerdem wird vorgeschlagen, dass gemäß einer vorgesehenen Kontur der Leiterplatte Durchbrüche in den Nutzen eingebracht werden und dass die Leiterplatten lediglich über die Durchbrüche überbrückende Stege in dem Nutzen gehalten werden. Die Durchbrüche werden vorzugsweise in den Nutzen gefräst. Auch ein Sägen, Stanzen oder bohren der Durchbrüche wäre denkbar. Vorteilhafterweise verlaufen die Leiterbahnen von den Bauteilen bzw. Bauteilgruppen auf den Leiterplatten zu den Testpunkten auf dem Nutzenrand über diese Stege. Beim Vereinzeln der Leiterplatten aus dem Nutzen werden beim Durchtrennen der Stege auch die Leiterbahnen zu den Testpunkten getrennt. So kann z.B. ein Mikroprozessor, der auf einer Leiterplatte im Nutzen angeordnet ist, im Nutzen über die Testpunkte derart programmiert werden, dass das Speicherelement des Mikroprozessors von schreib- und lesegeschützt ist. Nach der Vereinzelung der Leiterplatten ist dies nicht mehr änderbar, da die entsprechenden Kontakte, die vorher in Form der Testpunkte auf dem Nutzenrand vorhanden waren, fehlen. Dies kann aus Sicherheitsgründen durchaus sinnvoll sein.

Ausführungsbeispiele der Erfindung sind in den Figuren dargestellt und werden in der nachfolgenden Beschreibung näher erläutert. Es zeigen, jeweils in schematischer Form:
- Figur 1: ein Nutzen aus dem Stand der Technik mit acht Leiterplatten in einer Draufsicht;
- Figur 2: eine Detailansicht einer bestückten Leiterplatte aus dem Stand der Technik;
- Figur 3: eine Detailansicht einer Leiterplatte in einem erfindungsgemäßen Nutzen in einer ersten Ausführungsform; und
- Figur 4: eine Detailansicht einer Leiterplatte in einem erfindungsgemäßen Nutzen in einer zweiten Ausführungsform.

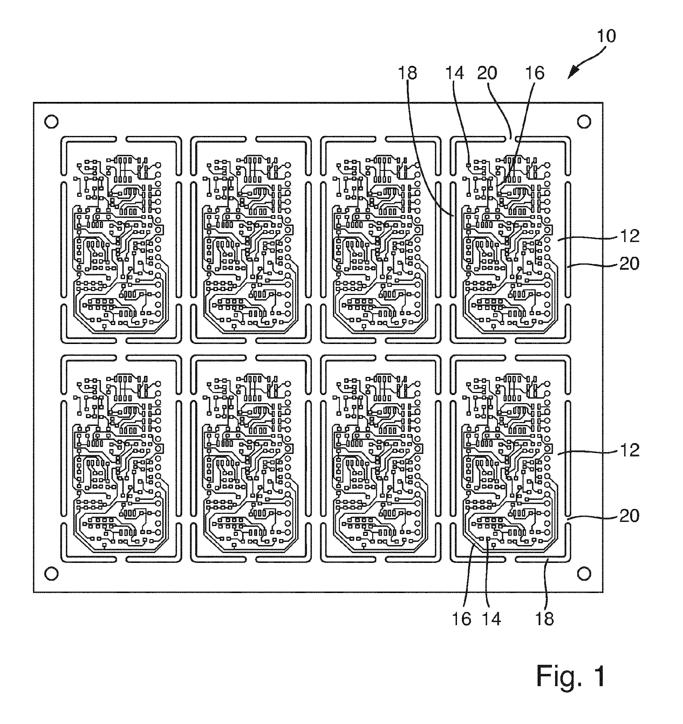

Figur 1 zeigt einen Nutzen 10 aus dem Stand der Technik mit acht Leiterplatten 12 in einer Draufsicht, wobei exemplarisch nur zwei Leiterplatten mit dem Bezugszeichen 12 gekennzeichnet sind. Der dargestellte Nutzen 10 umfasst acht gleichartig ausgebildete Leiterplatten 12. Ein Nutzen 10 könnte aber auch verschiedene Leiterplatten, die unterschiedlich ausgebildet und bestückt sind, umfassen. Die Leiterplatten 12 weisen auf der dargestellten Seite Kontaktierungspunkte 14 für elektrische bzw. elektronische Bauteile und Leiterbahnen 16 auf. Auch die Kontaktierungspunkte und Leiterbahnen sind nur exemplarisch mit den Bezugszeichen 14 bzw. 16 gekennzeichnet. Auf der nicht sichtbaren Seite der Leiterplatten 12 können beliebige elektrische oder elektronische Bauteile angeordnet und kontaktiert sein, wobei mehrere Bauteile einer Leiterplatte 12 gemeinsam eine Bauteilgruppe bilden können. Selbstverständlich können auf der gegenüberliegenden, bestückten Seite der Leiterplatten 12 (nicht sichtbar) auch Leiterbahnen und Kontaktierungspunkte angeordnet sein.

Gemäß einer vorgesehenen Kontur der Leiterplatten 12 sind Durchbrüche 18 in den Nutzen 10 eingebracht worden, bspw. mittels Fräsen. Die Durchbrüche 18 werden von mehreren zueinander beabstandeten Stegen 20 überbrückt. Die Stege 20 bilden also bspw. nicht herausgefräste Abschnitte. Das heißt, dass die Leiterplatten 12 durch die Stege 20 in dem Nutzen 10 gehalten werden. Für einen bestimmungsgemäßen Gebrauch der Leiterplatten 12 werden diese nach Fertigstellung und insbesondere vollständiger Bestückung mit Bauteilen aus dem Nutzen 10 herausgebrochen, herausgesägt, herausgestanzt oder anderweitig vereinzelt.

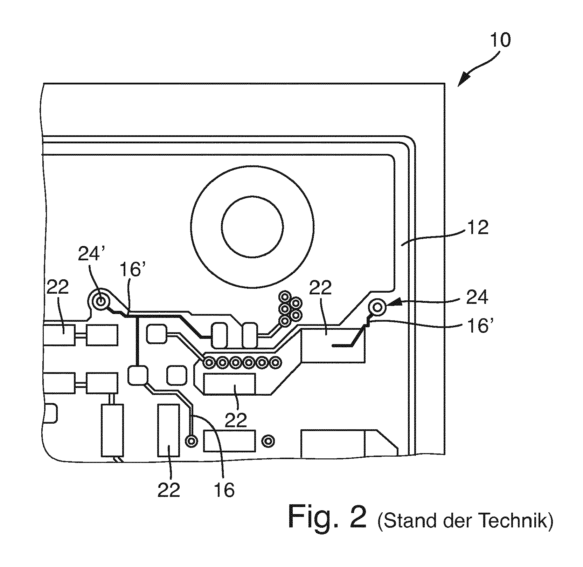

Figur 2 zeigt eine Detailansicht einer bestückten Leiterplatte 12 aus dem Stand der Technik. Auf der Leiterplatte 12 sind mehrere Bauteile 22 angeordnet, die über Leiterbahnen 16 elektrisch miteinander verbunden sind. Die Bezugszeichen sind den Leiterbahnen und Bauteile nur exemplarisch zugeordnet. Die Bauteile 22 sind bspw. Widerstände, Dioden, Transistoren, Halbleiterchips oder ähnliches. Die Detailansicht von Figur 2 zeigt darüber hinaus zwei auf der Leiterplatte 12 angeordnete Kontaktierungspunkte, die als Testpunkte 24 und 24' verwendet werden. Die Testpunkte 24, 24' sind über eigens dafür vorgesehene Leiterbahnen 16' mit einem oder mehreren Bauteilen 22 der Leiterplatte 12 verbunden.

Die Testpunkte 24, 24' dienen zum Überprüfen der auf der Leiterplatte 12 angeordneten Bauteile 22 z.B. über eine automatische Prüfeinrichtung (nicht dargestellt). Dabei können die Bauteile 22 auf ihre elektrischen Eigenschaften überprüft werden; es können aber auch funktionelle Tests der Bauteile 22 oder Bauteilgruppen ausgeführt werden. Auf die Testpunkte 24, 24' werden in der Regel Taststifte der Prüfeinrichtung aufgesetzt. An den Taststiften können elektrische Signale anliegen, mit denen die Bauteile 22 beaufschlagt werden. Über die Signale kann das über die Leiterbahn 16' kontaktierte Bauteil 22 oder eine gesamte Bauteilgruppe entsprechend geprüft werden. Wenn das Bauteil 22 ein Mikroprozessor ist, wäre es denkbar, diesen über die Testpunkte 24, 24' und die Taststifte mittels der Prüfeinrichtung zu programmieren. Die Taststifte können aber auch an den Testpunkten 24, 24' anliegende Signale erfassen und der Prüfeinrichtung zur Auswertung zuführen.

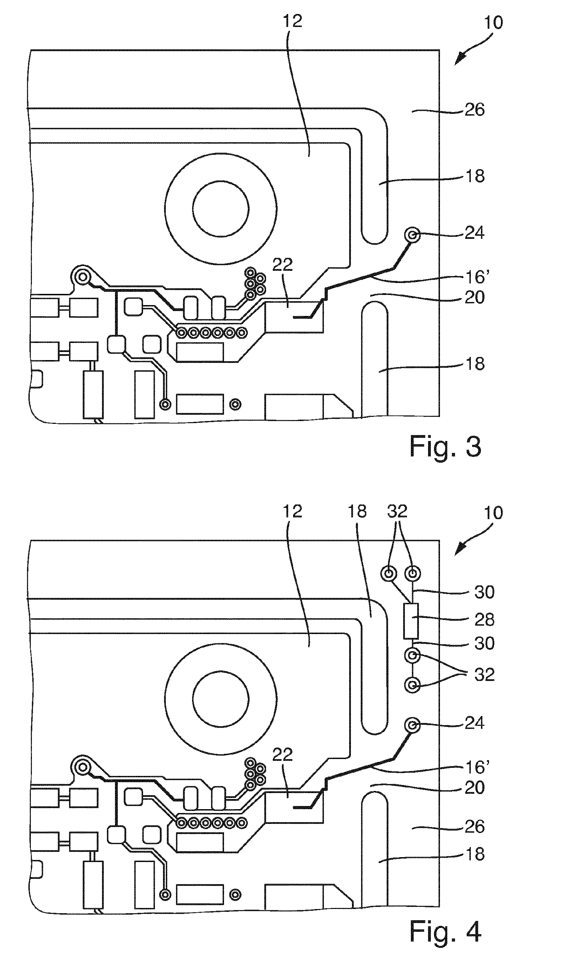

Figur 3 zeigt eine Detailansicht eines Teils einer Leiterplatte 12 als Bestandteil eines erfindungsgemäßen Nutzens 10 in einer ersten Ausführungsform. Gemäß der vorgesehenen Kontur der Leiterplatte 12 sind Durchbrüche 18 in den Nutzen 10 eingebracht, die von den Stegen 20 überbrückt werden. Außerhalb der Durchbrüche 18 ist ein Nutzenrand 26 ausgebildet, wobei der Nutzenrand 26 mit den Stegen 20 und der Leiterplatte 12 eine Einheit bildet. Die Leiterplatte 12 wird über die Stege 20 in dem Nutzen 10 gehalten.

Im Unterschied zu Figur 2 ist in Figur 3 der Testpunkt 24 durch eine Verlängerung der Leiterbahn 16' von der Leiterplatte 12 auf den Nutzenrand 26 verlegt worden. Dies schafft freie Fläche auf der Leiterplatte 12, die für zusätzliche Leiterbahnen und/oder Bauteile genutzt werden kann. Alternativ kann die Leiterplatte 12 auch durch ein verändertes Schaltungs- und Bauteile-Layout verkleinert werden. Die Verlegung des Testpunktes 24 beeinträchtigt die Prüfung des Bauteils 22 bzw. der Bauteilgruppe, bspw. über die automatische Prüfeinrichtung, nicht.

In Figur 4 ist zu der in Figur 3 gezeigten Verlegung des Testpunktes 24 zusätzlich ein aktives oder passives, elektrisches oder elektronisches Bauteil 28 auf dem Nutzenrand 26 angeordnet. Das Bauteil 28 auf dem Nutzenrand hat die gleichen elektrischen Eigenschaften wie die entsprechenden Bauteile 22 auf der Leiterplatte 12. Vorzugsweise stammen die Bauteile 22 der Leiterplatte 12 und das Bauteil 28 auf dem Nutzenrand 26 aus dem gleichen Fertigungslos. Das Bauteil 28 ist über eigens vorgesehene Leiterbahnen 30 mit Testpunkten 32 kontaktiert, wobei die Testpunkte 32 auch auf dem Nutzenrand 26 angeordnet sind. Durch die Testpunkte 32 kann das Bauteil 28 bspw. mittels Taststifte über die automatische Prüfeinrichtung exakt vermessen werden.

Natürlich kann auf dem Nutzenrand 26 auch ausschließlich das zusätzliches Bauteil 28 mit den zugeordneten Testpunkten 32 und den Zuleitungen 30, also ohne den von der Leiterplatte 12 weg auf den Nutzenrand 26 verlegten Testpunkt 24, angeordnet werden. Anstatt eines einzelnen Bauteils 28 kann auch eine Bauteilgruppe umfassend mehrere Bauteile auf dem Nutzenrand 26 angeordnet werden. Beim Testen kann dann die gesamte Bauteilgruppe vermessen bzw. funktional geprüft werden.

Beim Testen des Bauteils 28 kann dann bspw. festgestellt werden, ob die Leiterplatte 12 versehentlich mit Bauteilen 22 mit nicht vorgesehenen elektrischen Eigenschaften bestückt wurde. Da alle diese Bauteile 22, 28 aus dem gleichen Fertigungslos stammen, kann man davon ausgehen, dass ein Fehler, der bei dem Bauteil 28 ermittelt wurde, auch auf den Leiterplatten 12 des Nutzens 10 vorliegt.

Wie aus Figur 4 ersichtlich ist, sind am Eingang und am Ausgang des Bauteils 28 jeweils zwei Testpunkte 32 vorgesehen. Dies ist z.B. dann sinnvoll, wenn es sich bei dem Bauteil 28 z.B. um ein sensibles Bauteil, z.B. einen niederohmigen Widerstand, handelt. Um einen solchen Widerstand genau zu vermessen, ist es nötig, zunächst einen bestmöglichen Kontakt des Taststiftes der Prüfeinrichtung mit dem Testpunkt 32 sicherzustellen. Dazu kann die Prüfeinrichtung jeweils zunächst zwischen den Testpunkten 32 zu beiden Seiten des Bauteils 28 am Eingang und dann am Ausgang eine im Wesentlichen widerstandslose Verbindung zwischen Taststiften und Testpunkt 32 feststellen. Auch eine eventuell vorhandene, statische Ladung, z.B. zwischen den Taststiften, kann ein Testergebnis beeinflussen und kann auf diese Weise abgebaut werden. Anschließend kann das sensible Bauelement 28 über einen einzigen Testpunkt 32 am Eingang und einen einzigen Testpunkt 32 am Ausgang genau vermessen werden. Werden keine sensiblen Bauteile getestet, ist ein Testpunkt 32 jeweils am Eingang und am Ausgang des Bauteils 28 ausreichend.

Mit der vorliegenden Erfindung ist es ferner möglich, die Kontaktierung zwischen Taststiften der Prüfeinrichtung und den Testpunkten 24, 32 wesentlich sicherer und zuverlässiger zu gestalten. Der Grund dafür ist, dass die Testpunkte 24, 32 auf dem Nutzenrand 26 in unmittelbarer Nähe zu ebenfalls im Nutzenrand 26 angeordneten Haltebereichen vorgesehen sind, an denen der Nutzen 10 mittels Greifer, Sauger o.ä. Haltevorrichtungen gehalten wird. Auf diese Weise können die Taststifte eine größere Kraft auf die Testpunkte 24, 32 ausüben. Bei weiter von den Haltebereichen entfernt angeordneten Testpunkten (vgl. Fig. 2), bspw. auf den Leiterplatten 12 angeordneten Testpunkten 24, 24', würde die Leiterplatte 12 bei großer Kraftbeaufschlagung elastisch nachgeben.

In allen Ausführungsformen können die Leiterplatten 12 im Nutzen 10 über die Testpunkte 24 bzw. 32 getestet werden. Nach einem erfolgreichen Test werden die Leiterplatten 12 für einen bestimmungsgemäßen Gebrauch der Leiterplatte 12 aus dem Nutzen 10 herausgebrochen, herausgesägt oder anderweitig vereinzelt. Die Leiterbahnen 16', welche die elektrische Verbindung zwischen den zu testenden Bauteilen 22 bzw. Bauteilgruppen auf der Leiterplatte 12 und den Testpunkten 24 auf dem Nutzenrand 26 herstellen, werden dabei zwangsläufig durchtrennt.

## Patentansprüche

1. Nutzen (10) umfassend mehrere Leiterplatten (12) und einen außerhalb der Leiterplatten (12) angeordneten Nutzenrand (26), wobei auf mindestens einer der Leiterplatten (12) mindestens ein Bauteil (22; 28) angeordnet ist und mindestens eines der Bauteile (22; 28) über mindestens eine Leiterbahn (16'; 30) mit mindestens einem Testpunkt (24; 32) zum Überprüfen des bestückten Bauteils elektrisch verbunden ist, **dadurch gekennzeichnet, dass** mindestens ein Testpunkt (24; 32) auf dem Nutzenrand (26) außerhalb der Leiterplatten (12) angeordnet ist.

2. Nutzen (10) nach Anspruch 1, **dadurch gekennzeichnet, dass** alle Testpunkte (24; 32) des Nutzens (10) auf dem Nutzenrand (26) angeordnet sind.

3. Nutzen (10) nach Anspruch 1 oder 2, **dadurch gekennzeichnet, dass** die mindestens eine Leiterbahn (16') von dem mindestens einen Bauteil (22) von der Leiterplatte (12) nach außen auf den Nutzenrand (26) geführt ist und den mindestens einen Testpunkt (24) kontaktiert.

4. Nutzen (10) nach einem der Ansprüche 1 bis 3, **dadurch gekennzeichnet, dass** auf mehreren Leiterplatten (12) Bauteile (22) mit gleichen elektrischen Eigenschaften angeordnet sind und dass auf dem Nutzenrand (26) mindestens ein zusätzliches Bauteil (28) mit den gleichen elektrischen Eigenschaften angeordnet und mit mindestens einem Testpunkt (32) auf dem Nutzenrand (26) elektrisch kontaktiert ist.

5. Nutzen (10) nach Anspruch 4, **dadurch gekennzeichnet, dass** die Bauteile (28) mit gleichen elektrischen Eigenschaften alle aus dem gleichen Fertigungslos stammen.

6. Nutzen (10) nach einem der vorhergehenden Ansprüche, **dadurch gekennzeichnet, dass** die Leiterplatten (12) in dem Nutzen (10) von bereichsweise eingebrachten Durchbrüchen (18) umgeben sind und durch Stege (20) in dem Nutzen (10) fixiert sind.

7. Nutzen (10) nach Anspruch 6, **dadurch gekennzeichnet, dass** die mindestens eine Leiterbahn (16') zu dem mindestens einen Testpunkt (24) auf dem Nutzenrand (26) auf den Stegen (20) verläuft.

8. Verfahren zum Herstellen von Leiterplatten (12) in einem Nutzen (10), wobei auf mindestens einer der Leiterplatten (12) mindestens ein Bauteil (22; 28) angeordnet wird, und mindestens eines der Bauteile (22; 28) über mindestens eine Leiterbahn (16'; 30) mit mindestens einem Testpunkt (24; 32) zum Überprüfen des bestückten Bauteils (22; 28) elektrisch verbunden wird, **dadurch gekennzeichnet, dass** mindestens ein Testpunkt (24; 32) auf einem Nutzenrand (26) außerhalb der Leiterplatten (12) angeordnet wird.

9. Verfahren nach Anspruch 8, **dadurch gekennzeichnet, dass** alle Testpunkte (24; 32) des Nutzens (10) auf dem Nutzenrand (26) angeordnet werden.

10. Verfahren nach Anspruch 8 oder 9, **dadurch gekennzeichnet, dass** die mindestens eine Leiterbahn (16') von dem mindestens einen Bauteil (22) von der Leiterplatte (12) nach außen auf den Nutzenrand (26) geführt wird und dadurch der mindestens eine Testpunkt (24) kontaktiert wird.

11. Verfahren nach einem der Ansprüche 8 bis 10, **dadurch gekennzeichnet, dass** auf mehreren Leiterplatten (12) Bauteile (22) mit gleichen elektrischen Eigenschaften angeordnet werden und dass auf dem Nutzenrand (26) mindestens ein zusätzliches Bauteil (28) mit den gleichen elektrischen Eigenschaften angeordnet und mit dem mindestens einen Testpunkt (32) auf dem Nutzenrand (26) elektrisch kontaktiert wird.

12. Verfahren nach Anspruch 11, **dadurch gekennzeichnet, dass** die Bauteile (28) mit gleichen elektrischen Eigenschaften alle aus dem gleichen Fertigungslos ausgewählt und in dem Nutzen (10) verwendet werden.

13. Verfahren nach einem der Ansprüche 8 bis 12, **dadurch gekennzeichnet, dass** gemäß einer vorgesehenen Kontur der Leiterplatte (12) Durchbrüche (18) in den Nutzen (10) eingebracht werden und dass die Leiterplatte (12) über die Durchbrüche (18) überbrückende Stege (20) in dem Nutzen (10) gehalten werden.

14. Verfahren nach Anspruch 13, **dadurch gekennzeichnet, dass** die mindestens eine Leiterbahn (16') zu dem mindestens einen Testpunkt (24) über die Stege (20) verläuft und beim Vereinzeln der Leiterplatten (12) aus dem Nutzen (10) beim Durchtrennen der Stege (20) auch die Leiterbahnen (16') zu den Testpunkten (24) getrennt werden.
